# EUROPEAN PATENT SPECIFICATION

(11) **EP 4 350 308 B1**
(45) Date of publication and mention of the grant of the patent: **08.07.2026**
(21) Application number: 22815596.6
(22) Date of filing: 01.03.2022
(51) Int. Cl.: H10F 39/00, B81B 7/00, G01J 5/00

(54) **SEMICONDUCTOR SENSOR AND METHOD FOR MANUFACTURING SAME**
HALBLEITERSENSOR UND VERFAHREN ZUR HERSTELLUNG DAVON
CAPTEUR À SEMI-CONDUCTEUR ET SON PROCÉDÉ DE FABRICATION

(30) Priority: 03.06.2021 JP 2021093637
(43) Date of publication of application: 10.04.2024
(73) Proprietor: MITSUBISHI ELECTRIC CORPORATION, Chiyoda-ku Tokyo 100-8310 (JP)
(72) Inventor: HANAOKA, Misaki, Tokyo 100-8310 (JP); HATA, Hisatoshi, Tokyo 100-8310 (JP)
(74) Representative: Meissner Bolte Partnerschaft mbB
(86) International application number: PCT/JP2022/008619
(87) International publication number: WO 2022/254838

(56) References cited:
- WO-A1-2005/015637
- JP-A- 2010 216 819
- JP-A- 2011 033 393
- JP-A- 2013 036 766
- JP-A- 2017 167 131
- JP-A- 2017 203 737
- JP-A- 2019 504 298
- JP-A- H09 506 712
- JP-A- H10 239 157
- US-A1- 2002 175 284
- FENG FEI ET AL: "MEMS based vacuum packaging method of optically readable infrared focal plane array", MICROSYSTEM TECHNOLOGIES, BERLIN, DE, vol. 23, no. 6, 28 June 2016 (2016-06-28), pages 1793 - 1798, XP036237964, ISSN: 0946-7076, [retrieved on 20160628], DOI: 10.1007/S00542-016-3036-7

## Description

### Technical Field

The present invention relates to a semiconductor sensor having hollow structure bodies and a method for manufacturing the same.

### Background

Vacuum sealing is necessary for a semiconductor sensor having a hollow structure. In order to maintain a vacuum degree inside the vacuum sealing, a getter as an adsorbent of residual gas is built therein. For reducing costs for a sensor, a pixel-level vacuum sealing technique has been employed in recent years. Formation of getter on a lower portion or on a wall surface of a hollow structure can be achieved using a MEMS (microelectromechanical systems) technique by forming a surface with a sacrificial layer on a structure with a getter applied thereon and forming a thin film as a hollow structure (see Patent Literature 1, for example).

Further relevant background art may be found in Non-Patent Literature 1 which relates to a MEMS based vacuum packaging method is developed for uncooled optically readable infrared focal plane array (OR-IRFPA). The vacuum packaging structure is made up of three layers: a glass visible window, a silicon spacer, and a silicon infrared window. The silicon spacer is bonded with the glass visible window to form two cavities: one cavity for getter and another one for OR-IRFPA. The isolation wall with micrometer scale pores is designed to ensure air's free flow between two cavities and prevent getter powder from hanning pixels of OR-IRFPA. The infrared window is used as cover board and selectively transmitting 8-14 µm infrared radiation.

### Citation List

### Patent Literature

| | | |
|---|---|---|
| [PTL 1] | U.S. Patent Application Publication | US 2002/0175284A1 |

### Non-Patent Literature

| | | |
|---|---|---|
| [NPTL 1] | FENG FEI ET AL: "MEMS based vacuum packaging method of optionally readable infrared focal plane array" XP036237964 | |

### Summary

### Technical Problem

In recent years, cost reduction has been progressing by size reduction of pixels, and thus, in employment of a pixel-level vacuum sealing technique, an area of a getter which can be applied to an inside of the pixel has been decreased. Consequently, there has been a problem that maintenance performance of a vacuum degree of a hollow structure is lowered.

Further, there may be a case where it is difficult to employ the pixel-level vacuum sealing technique depending on a formation process of a pixel. For example, because in a case where the hollow structure is formed by etching a semiconductor, the getter cannot be applied to a lower portion of the hollow structure, the pixel-level vacuum sealing technique has not been employable. Further, it has been desired that a pixel array region be reduced while a sufficient getter area is secured for retaining a proper vacuum degree.

The present invention has been made for solving the above-described problems, and an object thereof is to obtain a semiconductor sensor and a method for manufacturing same which can prevent lowering of maintenance performance of a vacuum degree due to size reduction of a pixel without decreasing an area of a getter.

Further, another object thereof is to obtain a semiconductor sensor and a method for manufacturing same which can reduce a pixel array region while securing a sufficient getter area for retaining a proper vacuum degree.

### Solution to the Problem

A semiconductor sensor according to the present invention is outlined in independent claim 1.

A method, according to the present invention, for manufacturing a semiconductor device is outlined in independent claim 14.
Preferred embodiments of the present invention may be found in the dependent claims and the disclosure herein.

### Advantageous Effects of the Invention

In the semiconductor device according to the present invention, lowering of maintenance performance of the vacuum degree due to size reduction of the pixel can be prevented without decreasing an area of the getter. Further, even in a case where the hollow structure body is formed by etching of a semiconductor, pixel-level vacuum sealing can be employed.

### Brief Description of the Drawings

FIG. 1 is a plan view illustrating a wafer used for manufacturing of a semiconductor sensor according to a first embodiment.
FIG. 2 is a plan view in which a part of the semiconductor sensor in FIG. 1 is enlarged.
FIG. 3 is a plan view illustrating the detection part of the semiconductor sensor according to the first embodiment.
FIG. 4 is a diagram in which a cross section taken along line I-II in FIG. 3 is seen from a lateral position.
FIG. 5 is a plan view illustrating the getter part of the semiconductor sensor according to the first embodiment.
FIG. 6 is a diagram in which a cross section taken along line I-II in FIG. 5 is seen from a lateral position.
FIG. 7 is a cross-sectional view illustrating a method for manufacturing the semiconductor sensor according to the first embodiment.
FIG. 8 is a cross-sectional view illustrating a method for manufacturing the semiconductor sensor according to the first embodiment.
FIG. 9 is a cross-sectional view illustrating a method for manufacturing the semiconductor sensor according to the first embodiment.
FIG. 10 is a cross-sectional view illustrating a method for manufacturing the semiconductor sensor according to the first embodiment.
FIG. 11 is a cross-sectional view illustrating a method for manufacturing the semiconductor sensor according to the first embodiment.
FIG. 12 is a cross-sectional view illustrating a method for manufacturing the semiconductor sensor according to the first embodiment.
FIG. 13 is a cross-sectional view illustrating a method for manufacturing the semiconductor sensor according to the first embodiment.
FIG. 14 is a cross-sectional view illustrating a method for manufacturing the semiconductor sensor according to the first embodiment.
FIG. 15 is a cross-sectional view illustrating a method for manufacturing the semiconductor sensor according to the first embodiment.
FIG. 16 is a cross-sectional view illustrating a method for manufacturing the semiconductor sensor according to the first embodiment.
FIG. 17 is a cross-sectional view illustrating a method for manufacturing the semiconductor sensor according to the first embodiment.
FIG. 18 is a cross-sectional view illustrating a method for manufacturing the semiconductor sensor according to the first embodiment.
FIG. 19 is a cross-sectional view illustrating a method for manufacturing the semiconductor sensor according to the first embodiment.
FIG. 20 is a cross-sectional view illustrating a method for manufacturing the semiconductor sensor according to the first embodiment.
FIG. 21 is a cross-sectional view illustrating a method for manufacturing the semiconductor sensor according to the first embodiment.
FIG. 22 is a cross-sectional view illustrating a method for manufacturing the semiconductor sensor according to the first embodiment.
FIG. 23 is a cross-sectional view illustrating a method for manufacturing the semiconductor sensor according to the first embodiment.
FIG. 24 is a cross-sectional view illustrating a method for manufacturing the semiconductor sensor according to the first embodiment.
FIG. 25 is a plan view illustrating a semiconductor sensor according to a second embodiment.
FIG. 26 is a plan view illustrating a semiconductor sensor according to a third embodiment.
FIG. 27 is a cross-sectional view illustrating a getter part of a semiconductor sensor according to a fourth embodiment.
FIG. 28 is a cross-sectional view illustrating a getter part of a semiconductor sensor according to a fifth embodiment.
FIG. 29 is a cross-sectional view illustrating a method for manufacturing the semiconductor sensor according to the fifth embodiment.
FIG. 30 is a cross-sectional view illustrating a method for manufacturing the semiconductor sensor according to the fifth embodiment.
FIG. 31 represents a plan view and a circuit diagram which illustrate a getter part of a semiconductor sensor according to a sixth embodiment.
FIG. 32 is a cross-sectional view taken along line I-II in FIG. 31.
FIG. 33 is a plan view illustrating a semiconductor sensor according to a seventh embodiment.
FIG. 34 is a cross-sectional view illustrating a semiconductor sensor according to an eighth embodiment.
FIG. 35 is a plan view illustrating the semiconductor sensor according to the eighth embodiment.
FIG. 36 is a cross-sectional view illustrating a method for manufacturing the semiconductor sensor according to the eighth embodiment.
FIG. 37 is a plan view illustrating the method for manufacturing the semiconductor sensor according to the eighth embodiment.

### Description of Embodiments

A semiconductor sensor and a method for manufacturing same according to the embodiments of the present invention will be described with reference to the drawings. The same components will be denoted by the same symbols, and the repeated description thereof may be omitted.

### First Embodiment

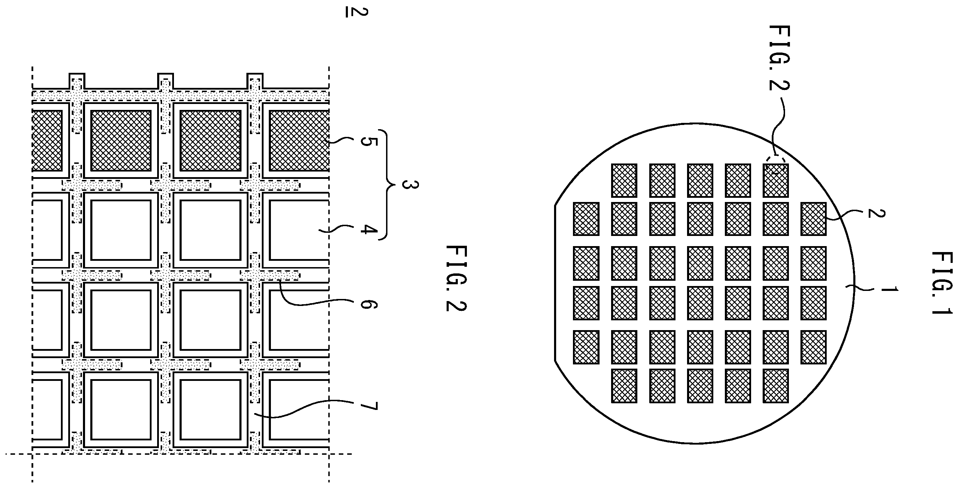

FIG. 1 is a plan view illustrating a wafer used for manufacturing of a semiconductor sensor according to a first embodiment. A semiconductor substrate 1 is a wafer-shaped Si substrate or SOI (silicon-on-insulator) substrate. Plural semiconductor sensors 2 are formed on the semiconductor substrate 1.

FIG. 2 is a plan view in which a part of the semiconductor sensor in FIG. 1 is enlarged. Plural hollow structure bodies 3 are formed in the semiconductor substrate 1 in an array manner. Each of the plural hollow structure bodies 3 has a detection part 4 as a hollow structure and a getter part 5 as a hollow structure different from the detection part 4. A support body 6 demarcates the plural hollow structure bodies 3. The getter part 5 is arranged in a position in which that does not hinder image detection or space information detection by the detection part 4 and is arranged at an end of the sensor herein. Note that the getter parts 5 may be arranged throughout plural columns at the end of the sensor. The detection part 4 and the getter part 5, and the detection parts 4 adjacent with each other are spatially joined together by respective tunnel portions 7 formed in the support body 6 and share a vacuum space. The tunnel portion 7 is a portion obtained by cavitating a part of the support body 6.

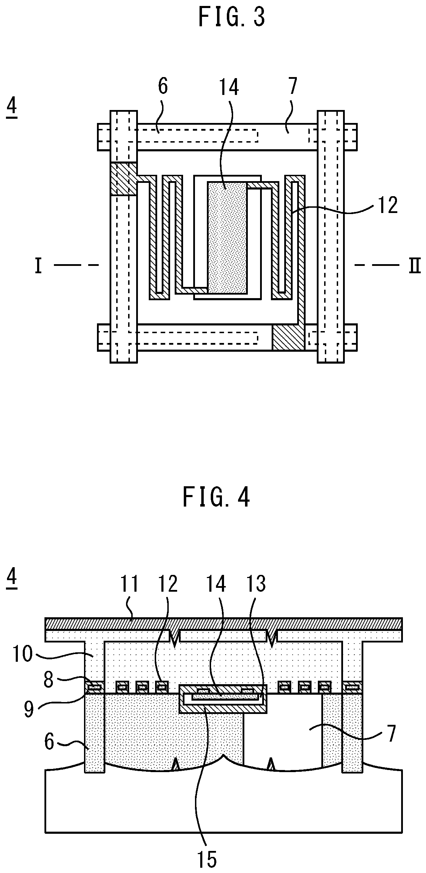

FIG. 3 is a plan view illustrating the detection part of the semiconductor sensor according to the first embodiment. FIG. 4 is a diagram in which a cross section taken along line I-II in FIG. 3 is seen from a lateral position. The support body 6, the tunnel portion 7, and a sealing material support body 10, which are present on deeper sides, can be seen in a see-through manner.

Wiring 8 is formed on the support body 6. The wiring 8 extends in a longitudinal direction and a lateral direction between the hollow structure bodies 3 for driving the sensor and for obtaining a signal and is connected with a scanning circuit formed with a switch, for example. An insulating layer 9 protects the wiring 8. The sealing material support body 10 is laminated on the support body 6 and covers the hollow structure body 3. A sealing material 11 is provided on the sealing material support body 10 and seals the plural hollow structure bodies 3 in a vacuum state.

In the hollow structure body 3 surrounded by the support body 6, a support leg 12 extends from the support body 6 and retains a hollow substrate 13 to be hollow. Material and shape of the support leg 12 are selected in accordance with a purpose of use of the sensor. In a case where the support leg 12 is formed as thermal insulation wiring, it is preferable that Ti or the like be used as a material with a small thermal conductance and the support leg 12 be designed to be as thin and long as possible. In order to avoid deformation of or a current leakage from the support leg 12, a surface of the support leg 12 may be covered by an insulating film formed of SiO₂ or the like. In a case where the support leg 12 is formed as the thermal insulation wiring, it is preferable that that be designed to be as thin and long as possible.

A detection device 14 is formed in the hollow substrate 13 in an internal portion of the detection part 4. The detection part 4 and the support leg 12 are retained to be hollow and are spaced away from the sealing material support body 10 and the semiconductor substrate 1. The detection device 14 is, as an infrared sensor, a thermal infrared detection device such as a PN junction diode, a resistance bolometer, or a thermopile, for example. In this case, the semiconductor sensor is an infrared sensor. The support leg 12 electrically connects the wiring 8 with the detection device 14. At least a lower surface of the hollow substrate 13 is covered by an oxide film 15. In addition, the detection device 14 may be used as a sensor accompanying the hollow structure such as a gas monitor, a pressure sensor, a vacuum gauge, or an acceleration sensor, but a configuration of the detection device 14 is different in accordance with the purpose of use.

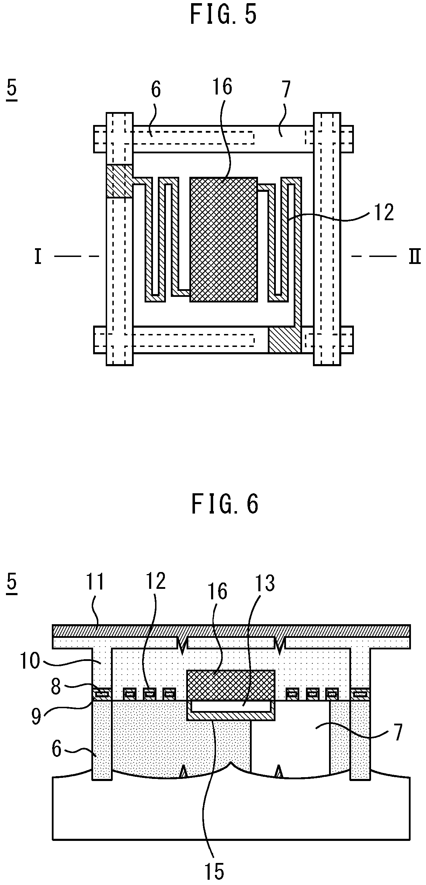

FIG. 5 is a plan view illustrating the getter part of the semiconductor sensor according to the first embodiment. FIG. 6 is a diagram in which a cross section taken along line I-II in FIG. 5 is seen from a lateral position. In an internal portion of the getter part 5, the getter 16 is applied onto the hollow substrate 13 which is retained to be hollow by the support leg 12. The getter 16 and the support leg 12 are retained to be hollow and are spaced away from the sealing material support body 10 and the semiconductor substrate 1. The getter 16 serves as an adsorbent of residual gas and is formed with a metal thin film of metal such as Ti, for example. Other structures are similar to those of the detection part 4 illustrated in FIG. 4. Note that in a case of no utilization as wiring, the wiring 8 is not necessary for the getter part 5.

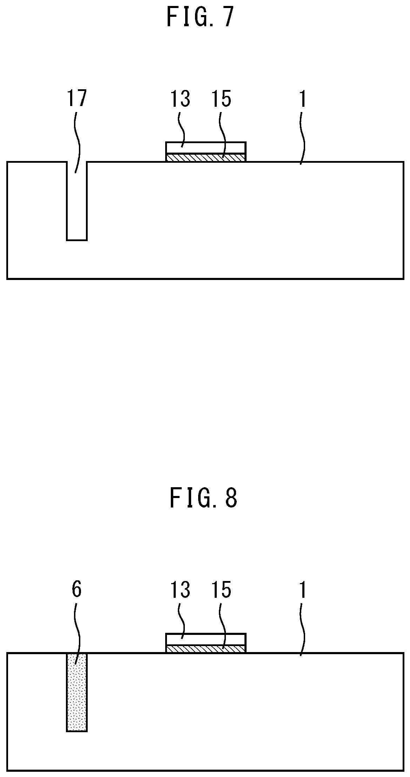

Next, a description will be made about methods for manufacturing the detection part 4 and the getter part 5 of the semiconductor sensor according to the present embodiment. FIG. 7 to FIG. 24 are cross-sectional views illustrating a method for manufacturing the semiconductor sensor according to the first embodiment. Those drawings correspond to cross-sectional views taken along line I-II in FIG. 3 or FIG. 5.

First, as illustrated in FIG. 7, the oxide film 15 is formed on a main surface of the semiconductor substrate 1, and the hollow substrate 13 is formed on the oxide film 15. A groove 17 is formed in the main surface of the semiconductor substrate 1 by etching. The hollow substrate 13 is formed by forming a film on the semiconductor substrate 1 or by etching a periphery of the hollow substrate 13. The groove 17 is formed in a position in which the support body 6 is subsequently formed. The groove 17 is not formed in a position in which the tunnel portion 7 is formed. It is desirable that a depth of the groove 17 be set to a length equivalent to or greater than half a length of one side of the hollow structure.

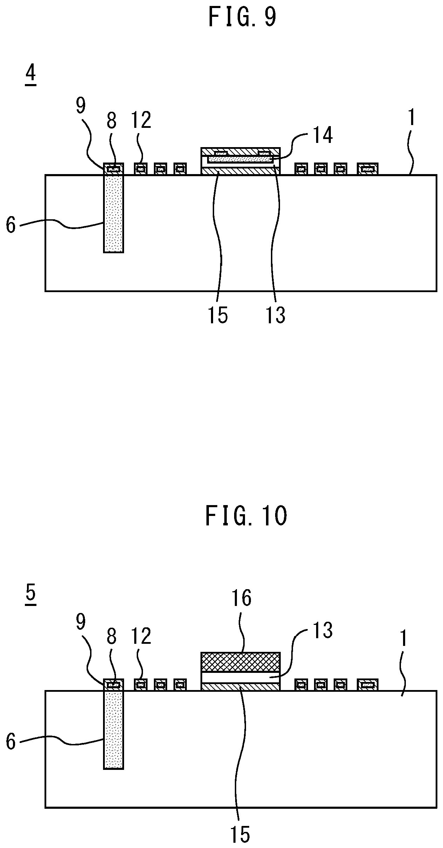

Next, as illustrated in FIG. 8, the groove 17 is filled with an oxide, and the support body 6 is thereby formed. Next, as illustrated in FIG. 9, in the detection part 4, the detection device 14 is formed in the hollow substrate 13. The detection device 14 is selected in accordance with the purpose of use of the sensor. In a case where the detection device 14 is used as a diode or a resistor, the detection device 14 is formed by ion implantation or the like, and an electric contact is formed with metal wiring of metal such as Al.

The wiring 8 is formed on the support body 6. The support leg 12 is formed so as to join the wiring 8 to the detection device 14 on the main surface of the semiconductor substrate 1. Further, as illustrated in FIG. 10, the support leg 12 and the wiring 8 are formed in the getter part 5, and the getter 16 is thereafter applied to the hollow substrate 13. Note that in a case of no utilization as wiring, the wiring 8 is not necessary for the getter part 5.

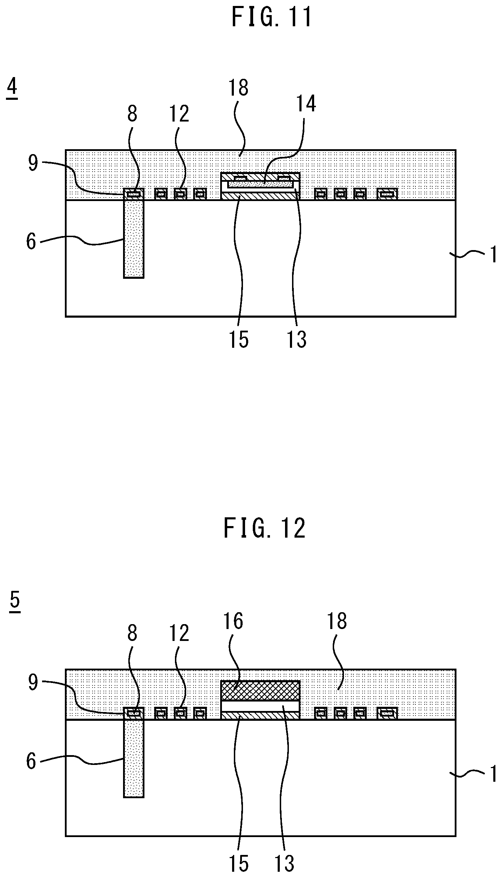

Next, as illustrated in FIG. 11, on the main surface of the semiconductor substrate 1, a sacrificial layer 18 is formed so as to cover the detection device 14, the wiring 8, and the support leg 12. A material of the sacrificial layer 18 is a material in which pattern formation is possible by a photomechanical technique and is an organic material having photosensitivity such as a photoresist, for example. As illustrated in FIG. 12, a similar process is performed for the getter part 5. A process for the detection part 4 which is illustrated in FIG. 11 and a process for the getter part 5 which is illustrated in FIG. 12 are performed at the same time. Note that in the following descriptions, the corresponding processes for the detection part 4 and for the getter part 5 are performed at the same time.

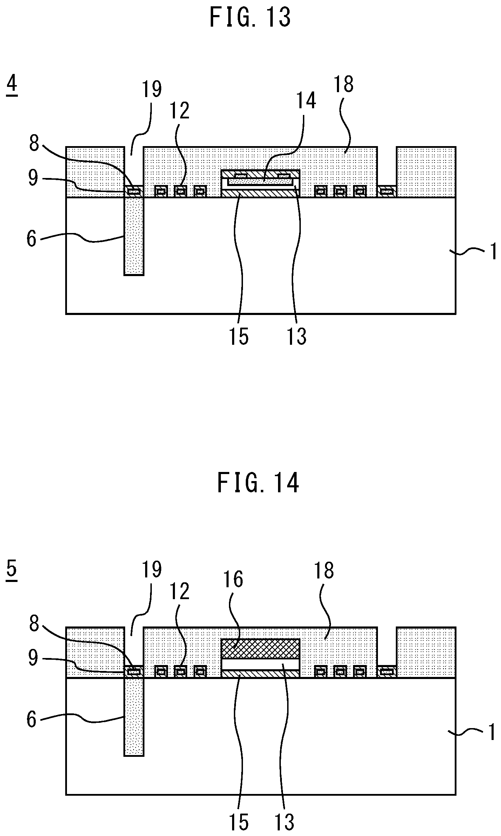

Next, as illustrated in FIG. 13, an opening 19 is formed by removing the sacrificial layer 18 on the wiring 8. In a case where a material of the sacrificial layer 18 is a photoresist, only the sacrificial layer 18 on the wiring 8 is removed by the photomechanical technique. As illustrated in FIG. 14, a similar process is performed for the getter part 5.

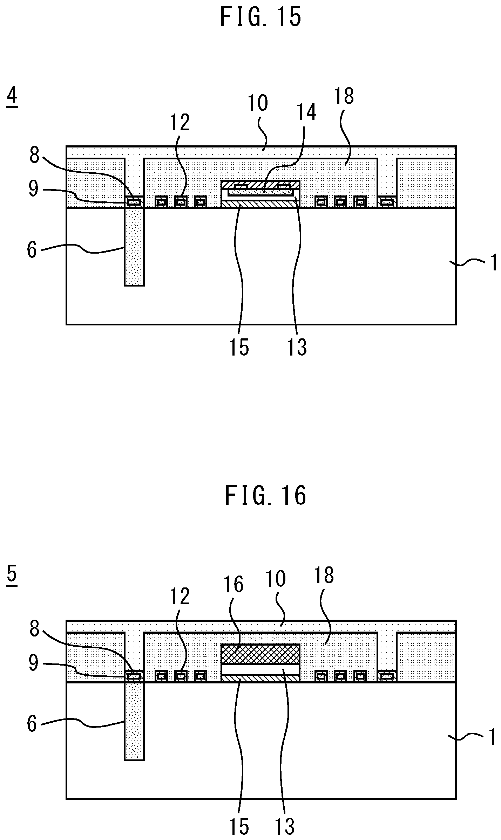

Next, as illustrated in FIG. 15, the sealing material support body 10 is formed by depositing an oxide, for example, in an internal portion of the opening 19 and on the sacrificial layer 18. As illustrated in FIG. 16, a similar process is performed for the getter part 5.

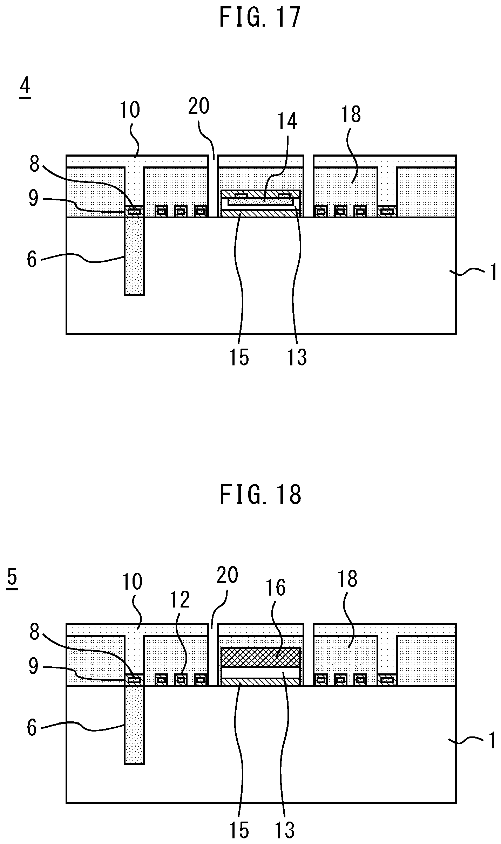

Next, as illustrated in FIG. 17, etching holes 20 are formed which pass through the sealing material support body 10 and the sacrificial layer 18 while avoiding the detection device 14 and the support leg 12. A part of the main surface of the semiconductor substrate 1 is exposed via the etching holes 20. As illustrated in FIG. 18, a similar process is performed for the getter part 5.

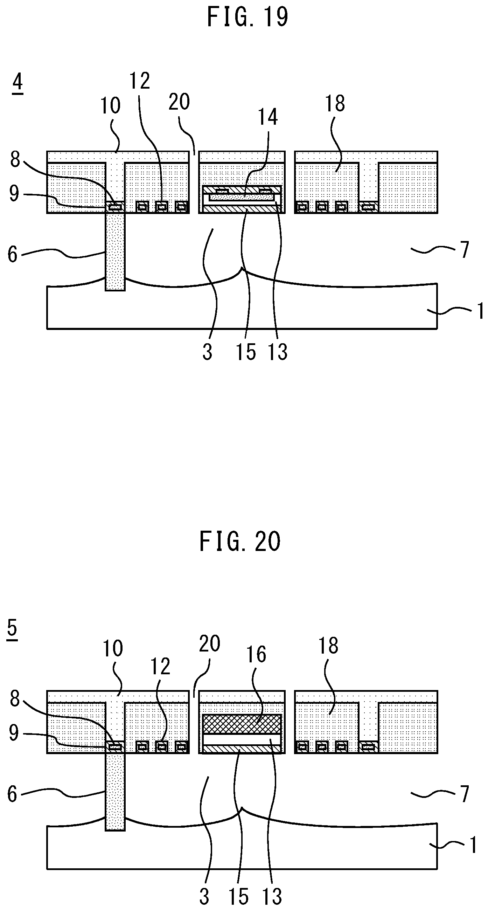

Next, as illustrated in FIG. 19, the hollow structure body 3 and the tunnel portion 7 are formed by selectively etching the semiconductor substrate 1 via the etching holes 20. As an etching method, a dry etching by xenon fluoride is used, for example. In this case, the support body 6, the sealing material support body 10, and the oxide film 15 are not etched because of the oxide, but only the semiconductor substrate 1 as a semiconductor such as Si is isotropically etched. The hollow substrate 13 and the detection device 14 are covered by the oxide film 15 and the sacrificial layer 18 and are thus not etched. The tunnel portion 7 is formed in a portion immediately below the wiring 8, in which the support body 6 is not formed. In a planar view, as illustrated in FIG. 2, except the tunnel portion 7, the support bodies 6 are not etched but remain below the wiring 8. As illustrated in FIG. 20, a similar process is performed for the getter part 5.

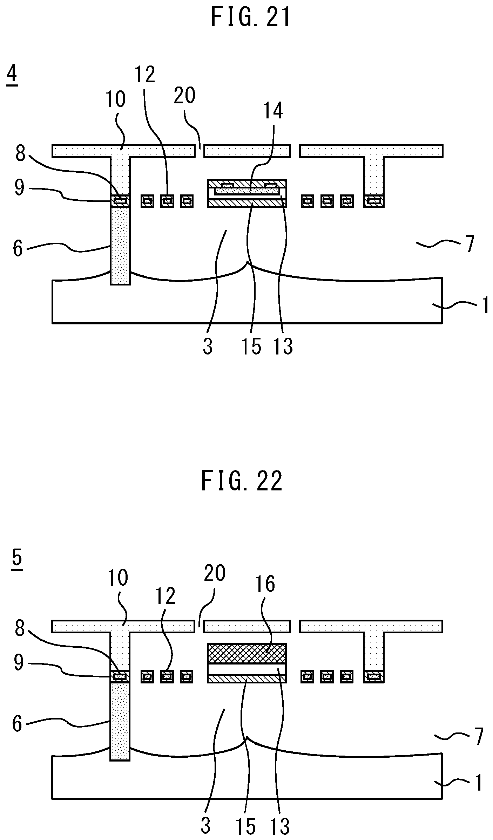

Next, as illustrated in FIG. 21, the whole sacrificial layer 18 is removed, and the support leg 12 and the detection device 14 are set to a hollow state. As illustrated in FIG. 22, a similar process is performed for the getter part 5.

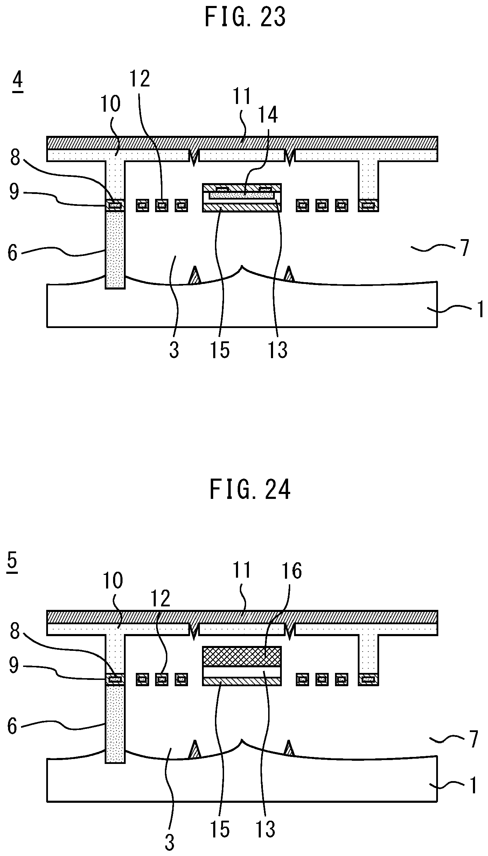

Next, as illustrated in FIG. 23, the etching holes 20 are blocked by depositing the sealing material 11 on the sealing material support body 10 under a vacuum condition, and the hollow structure body 3 is thereby sealed in a vacuum state. A material of the sealing material 11 is selected in accordance with the purpose of use of the sensor, but a material is desirable which can block the etching holes 20 under the vacuum condition and retain the vacuum state of the hollow structure body 3. In a case of an optical sensor such as an infrared sensor, a semiconductor such as ZnS or Si is selected as the material of the sealing material 11 taking into consideration transmittance characteristics and so forth. As illustrated in FIG. 24, a similar process is performed for the getter part 5.

In the above processes, the detection part 4 and the getter part 5 of the semiconductor sensor according to the present embodiment can be manufactured.

As described above, in the present embodiment, the getter 16 is formed in the internal portion of the getter part 5 as the hollow structure body 3 which is different from the detection part 4. Because the detection part 4 and the getter part 5 are joined together by the tunnel portion 7, a vacuum degree of the detection part can be retained. Consequently, because the getter 16 does not have to be formed in the same pixel as the detection part 4, lowering of maintenance performance of the vacuum degree due to size reduction of the pixel can be prevented without decreasing an area of the getter 16. Further, even in a case where the hollow structure body 3 is formed by etching of a semiconductor, pixel-level vacuum sealing can be employed.

Further, in the getter part 5, the getter 16 is applied onto the hollow substrate 13 which is retained to be hollow by the support leg 12. Accordingly, a sufficient space can be provided to the tunnel portion 7. Further, a thickness of the hollow substrate 13 is adjusted, and a thickness of the getter 16 can thereby also be adjusted.

The tunnel portion 7 is formed in a part of one side of the hollow structure body 3 in a planar view and is arranged to be spaced away from a corner of the hollow structure body 3. Accordingly, high strength of the wiring 8 formed on the support body 6 and of the hollow structure body 3 can be retained. Because the support bodies 6 retaining holding strength are present in four corners of the hollow structure body 3, the tunnel portions 7 may be formed in four sides of the hollow structure body 3.

### Second Embodiment

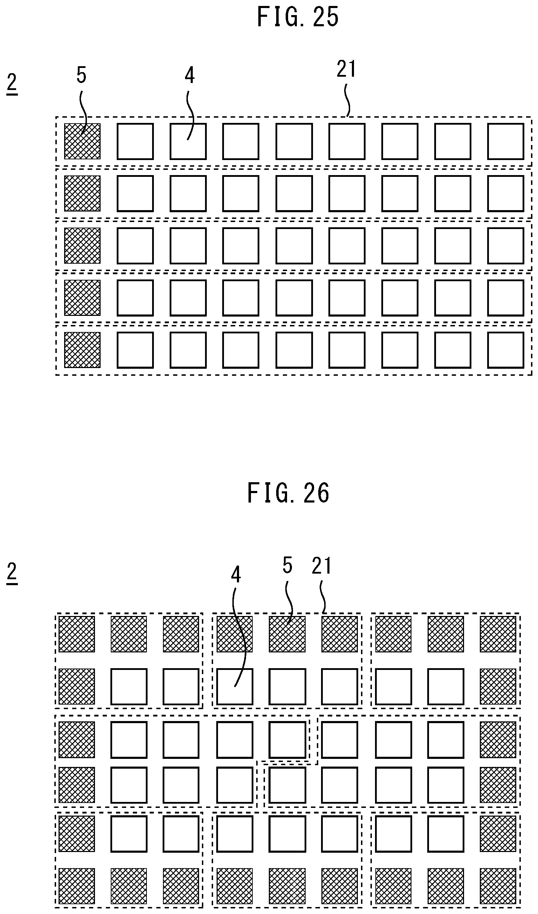

FIG. 25 is a plan view illustrating a semiconductor sensor according to a second embodiment. Plural hollow structure bodies 3 are separated into plural hollow structure groups 21 which are not spatially joined with each other. Each of the hollow structure groups 21 has at least one detection part 4 and one getter part 5.

In each of the hollow structure groups 21, the detection part 4 and the getter part 5 are spatially joined together via the tunnel portion 7. In the sensor, the hollow structure groups 21 are present for the numbers of columns or rows of the hollow structure bodies 3. The getter part 5 is arranged in a position, in which that does not hinder the image detection by the detection part 4 or the space information to be obtained, such as an edge of the sensor, for example. Plural getter parts 5 may be included in the hollow structure group 21, and for example, plural columns of the getter parts 5 are arranged at both ends or an end of the column, for example. Note that one hollow structure group 21 may be configured with plural columns. That is, the detection part 4 and the getter part 5 are spatially joined together via the tunnel portion 7 in at least one column.

Even when vacuum sealing of a part of the hollow structure groups 21 is broken, functions of the sensor can be retained by the hollow structure groups 21 whose vacuum sealing is not broken. Further, because the same vacuum degree is retained in the column, it is easy to correct differences in detection performance due to differences in the vacuum degree.

### Third Embodiment

FIG. 26 is a plan view illustrating a semiconductor sensor according to a third embodiment. In each of the hollow structure groups 21, the detection part 4 and the getter part 5 are spatially joined together via the tunnel portion 7 in each section which is formed with two or more rows and two or more columns. The hollow structure group 21 has at least one detection part 4 and one getter part 5. The hollow structure group 21 may have plural getter parts 5. For example, plural columns of the getter parts 5 are arranged on four sides at edges of the sensor or at an edge of the sensor, for example.

Similarly to the second embodiment, even when the vacuum sealing of a part of the hollow structure groups 21 is broken, the functions of the sensor can be retained by the hollow structure groups 21 whose vacuum sealing is not broken. Further, because the getter parts 5 can be arranged on the four sides at the edges of the sensor, the number of getter parts 5 included in one hollow structure group 21 can be increased.

### Fourth Embodiment

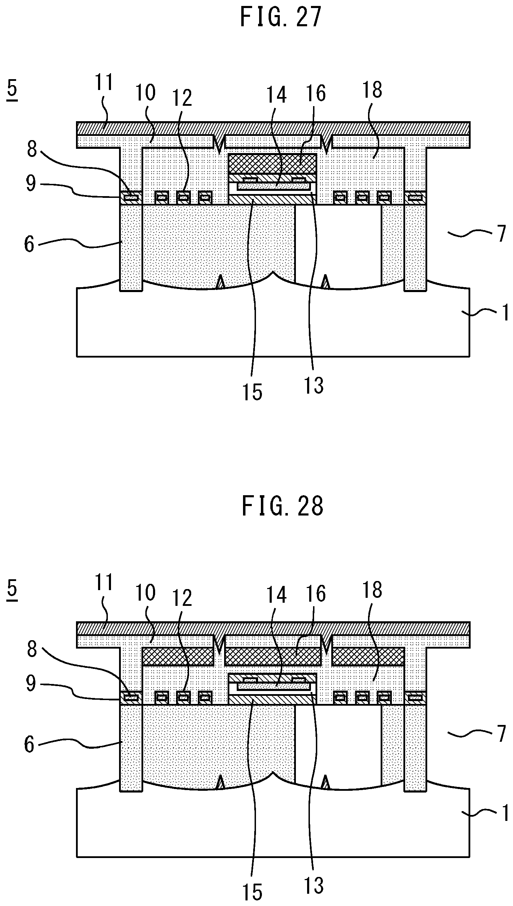

FIG. 27 is a cross-sectional view illustrating a getter part of a semiconductor sensor according to a fourth embodiment. In the present embodiment, not only in the detection part 4 but also in the getter part 5, the detection device 14 is formed in the hollow substrate 13 which is retained to be hollow by the support leg 12. In the getter part 5, the getter 16 is applied onto the hollow substrate 13 in which the detection device 14 is formed.

The getter 16 is formed of metal such as Ti, which is formed into a thin film, for example, and the metal reflects light such as visible light and infrared rays. For example, the metal having a somewhat thick film thickness is applied to the hollow substrate 13 in order to enhance reflectance, and incidence of light on the detection device 14 of the getter part 5 can thereby be prevented. In a case where the detection device 14 serves as an infrared sensor, the detection device 14 covered by the getter 16 cannot detect infrared rays. Thus, the getter part 5 can be utilized as a reference pixel for obtaining a signal of the detection device 14 which is not receiving infrared rays. However, it is not necessary to use all of the getter parts 5 as the reference pixels, but the getter parts 5 other than a necessary number of those may have the configuration of the first embodiment.

### Fifth Embodiment

FIG. 28 is a cross-sectional view illustrating a getter part of a semiconductor sensor according to a fifth embodiment. In the present embodiment, not only in the detection part 4 but also in the getter part 5, the detection device 14 is formed in the hollow substrate 13 which is retained to be hollow by the support leg 12. In the getter part 5, the getter 16 is applied onto an inner side of the sealing material support body 10 above the detection device 14, that is, an upper portion on an inner side of the hollow structure body 3. Note that formation of the detection device 14 in the getter part 5 is not necessarily required, and a configuration is possible in which no detection device 14 is provided in the getter part 5.

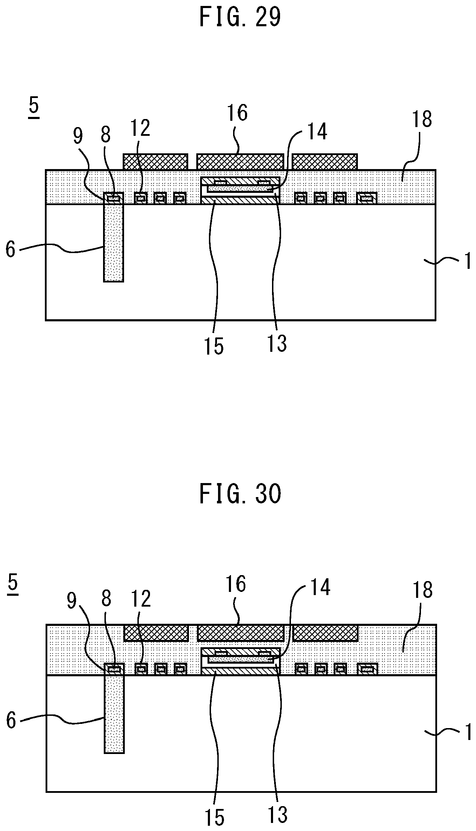

FIG. 29 and FIG. 30 are cross-sectional views illustrating a method for manufacturing the semiconductor sensor according to the fifth embodiment. In the detection part 4 and the getter part 5, similarly to FIG. 11 of the first embodiment, the detection device 14, the hollow substrate 13, the wiring 8, and the support leg 12 are formed, and the sacrificial layer 18 is thereafter formed. In this case, a thickness of the sacrificial layer 18 to be applied is set thin taking into consideration the thickness of the getter 16 to be applied to the getter part 5. As a guide, the thickness is set to such a thickness that surfaces of the hollow substrate 13, the support leg 12, and the wiring 8 are covered by the sacrificial layer 18 and a surface of the sacrificial layer 18 is not uneven but is flat.

Next, nothing is applied in the detection part 4. On the other hand, as illustrated in FIG. 29, in the getter part, the getter 16 is applied onto the sacrificial layer 18 except a portion above the wiring 8 and portions in which the etching holes 20 are subsequently formed.

Next, as illustrated in FIG. 30, the sacrificial layer 18 is further applied onto the sacrificial layer 18 so as not to cover the getter 16. A subsequent manufacturing process is similar to that of the first embodiment. Because the sealing material support body is formed on the getter 16, after the sacrificial layer 18 is removed, the getter 16 is formed on the inner side of the sealing material support body 10.

In the present embodiment, the getter 16 can be applied onto an inner surface of the hollow structure body 3 in portions other than the etching holes 20 and the wiring 8. Consequently, because an applying area of the getter 16 in the getter part 5 can be increased, vacuum maintaining performance is improved.

Similarly to the fourth embodiment, in the getter part 5, a portion above the detection device 14 is covered by the getter 16 formed of the metal. For example, the metal having a somewhat thick film thickness is applied in order to enhance reflectance, and incidence of light on the detection device 14 of the getter part 5 can thereby be prevented. In a case where the detection device 14 serves as an infrared sensor, the detection device 14 covered by the getter 16 cannot detect infrared rays. Thus, the getter part 5 can be utilized as a reference pixel for obtaining a signal of the detection device 14 which is not receiving infrared rays. However, it is not necessary to use all of the getter parts 5 as the reference pixels, but the getter parts 5 other than a necessary number of those may have the configuration of the first embodiment.

### Sixth Embodiment

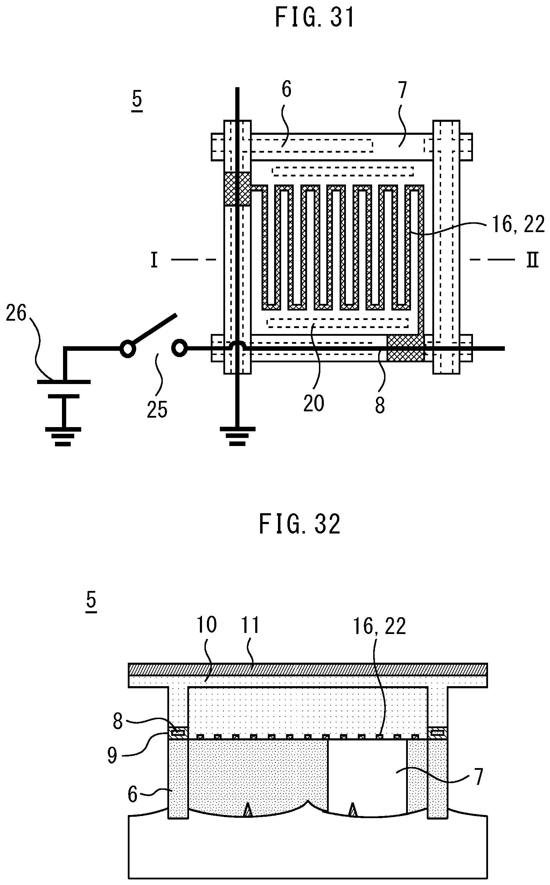

FIG. 31 represents a plan view and a circuit diagram which illustrate a getter part of a semiconductor sensor according to a sixth embodiment. FIG. 32 is a cross-sectional view taken along line **I-II** in FIG. 31. The getter 16 serves as thin hollow wiring 22 formed of metal such as Ti. The hollow wiring 22 is connected with a power source circuit, which includes a selection circuit 25 such as a switching circuit and a power source 26, via the wiring 8 and can selectively be electrically heated. The hollow wiring 22 functions as the getter 16 although not being electrically heated but can be activated as the getter 16 by being electrically heated. Consequently, when the vacuum state is degraded after the vacuum sealing, the vacuum degree can be improved by electrical heating. Other configurations are similar to those of the first embodiment, the vacuum degrees different among the hollow structure bodies 3 can respectively be adjusted to constant vacuum degrees.

Further, as the second and third embodiments, in a case where the plural hollow structure groups are provided, the vacuum degrees different among the hollow structure bodies can respectively be adjusted to constant vacuum degrees. Further, in a case where the fourth and fifth embodiments are combined together, the getter part 5 of the present embodiment is included in the same hollow structure group as the getter part 5 serving as the reference pixel, it thereby becomes possible to adjust the vacuum degree, and a stable output of the reference pixel can be obtained.

Because no hollow substrate 13 is provided to the getter part 5, the hollow wiring 22 which is thinly formed of Ti is formed on the semiconductor substrate 1 in the manufacturing process in FIG. 10 and is connected with the wiring 8. In this case, the hollow wiring 22 is made as long as possible. Accordingly, a resistance is made high, Ti is vaporized by a low current, and the vaporized Ti can thereby be activated as the getter 16. Other manufacturing processes are similar to those of the first embodiment. However, in a case where an interval in the hollow wiring 22 is narrow, a position of the etching hole 20 may be set to a portion between the hollow wiring 22 and the wiring 8. Here, the etching hole 20 is linearly provided between the hollow wiring 22 and the wiring 8.

### Seventh Embodiment

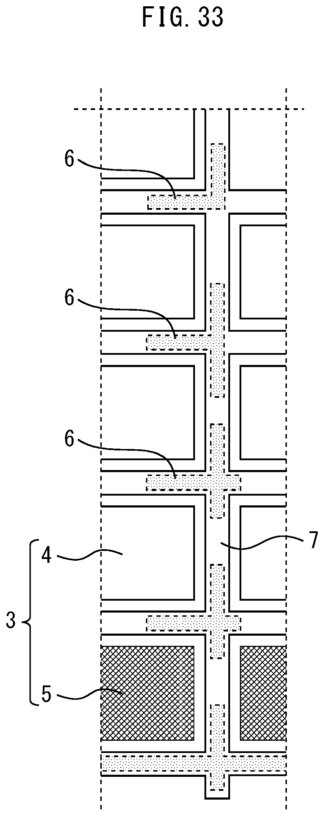

FIG. 33 is a plan view illustrating a semiconductor sensor according to a seventh embodiment. The tunnel portion 7 is formed by hollowing out the support body 6 in a part of one side of the hollow structure body 3, which has a rectangular shape in a planar view, and is arranged to be adjacent to a corner of the hollow structure body 3 in a planar view. Other configurations are similar to those of the first embodiment.

Similarly to the first embodiment, the support body 6 is formed by filling the groove 17 with an oxide, but a corner of the support body 6 might insufficiently be filled with the oxide. In the present embodiment, because a planar shape of the support body 6 are formed to be not a cross-shaped support but an L shape or a T shape, uniform support bodies 6 can be formed. Further, because the corner of the support body 6 is filled up and a surface area of the support body 6 which adsorbs residual gas is decreased, a retaining capability for the vacuum degree can be enhanced.

Further, because strength of the support body 6 becomes low when the tunnel portion 7 is formed in one whole side of the hollow structure body 3, the tunnel portions 7 cannot be formed in four sides of the hollow structure body 3. In a case where the tunnel portion 7 is formed in only a part of one side of the hollow structure body 3, the tunnel portions 7 can be formed in the four sides of the hollow structure body 3.

### Eighth Embodiment

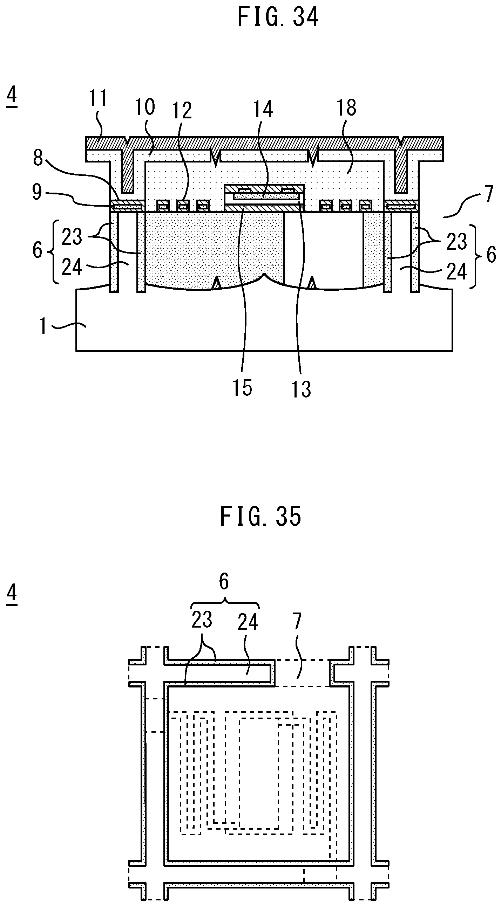

FIG. 34 is a cross-sectional view illustrating a semiconductor sensor according to an eighth embodiment. FIG. 35 is a plan view illustrating the semiconductor sensor according to the eighth embodiment. In the present embodiment, the support body 6 has a semiconductor 24 as a part of the semiconductor substrate 1 and an oxide 23 provided to surround the semiconductor 24 along an outer periphery of the support body 6. Because a lateral width of the support body 6 becomes wider than that of the first embodiment, broad wiring 8 can be formed on the support body 6.

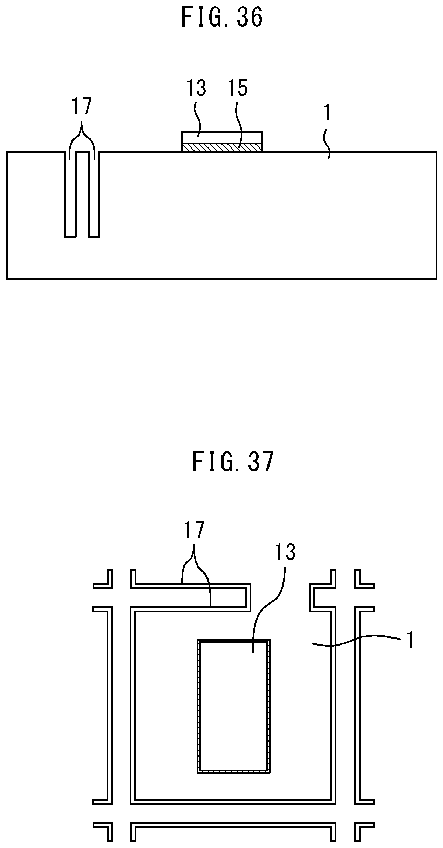

FIG. 36 is a cross-sectional view illustrating a method for manufacturing the semiconductor sensor according to the eighth embodiment. FIG. 37 is a plan view illustrating the method for manufacturing the semiconductor sensor according to the eighth embodiment. Two grooves 17 are side by side formed to be adjacent to each other. In this case, the grooves 17 are formed to join together in a position where the tunnel portion 7 is formed. Next, the support body 6 is formed by filling the groove 17 with an oxide, and the wiring 8 is formed on an upper portion of the support body 6. A manufacturing process subsequent to this is similar to that of the first embodiment. Even in the tunnel portion 7, a surface of the support body 6 is covered by the oxide 23. Thus, for example, when the semiconductor substrate 1 is etched by xenon fluoride, the semiconductor 24 configuring the support body 6 remains while being not etched.

In a case of a large-sized sensor with a large array scale, the wiring 8 has to be made broad in order to decrease a wiring resistance. However, when the groove 17 is formed to be broad in accordance with broadness of the wiring 8 in the first embodiment, it is difficult to uniformly fill the groove 17 with the oxide, and it becomes difficult to form the support body 6. On the other hand, as in the present embodiment, it is easier to form the support body 6 by arranging two grooves 17 side by side.

### List of Reference Signs

- 1: semiconductor substrate
- 3: hollow structure body
- 4: detection part
- 5: getter part
- 6: support body
- 7: tunnel portion
- 8: wiring
- 9: insulating layer
- 10: sealing material support body
- 11: sealing material
- 12: support leg
- 13: hollow substrate
- 14: detection device
- 15: oxide film
- 16: getter
- 17: groove
- 18: sacrificial layer
- 19: opening
- 20: etching hole
- 21: hollow structure group
- 22: hollow wiring
- 23: oxide
- 24: semiconductor
- 25: selection circuit
- 26: power source

## Claims

1. A semiconductor sensor comprising:
- a single semiconductor substrate (1);
- plural hollow structure bodies (3) formed in the semiconductor substrate (1) in an array manner and having a detection part (4) as a hollow structure and a getter part (5) as a hollow structure different from the detection part (4);
- a support body (6) demarcating the plural hollow structure bodies (3);
- a sealing material support body (10) laminated on the support body (6); and
- a sealing material (11) provided on the sealing material support body (10) and vacuum-sealing the plural hollow structure bodies (3),
- wherein the detection part (4) has a detection device (14) inside,
- the getter part (5) has a getter (16) inside,
- the detection part (4) and the getter part (5) are spatially joined together by a tunnel portion (7) formed in the support body (6) to constitute a hollow structure group (21) sharing a vacuum space, and
- the detection part (4) and the getter part (5) of the hollow structure group (21) are sealed per the hollow structure in a vacuum space closed and separated by the sealing material (11) and the support body (6) respectively.

2. The semiconductor sensor according to claim 1,
comprising:
wiring (8) formed on the support body (6); and
a support leg (12) retaining the detection device (14) to be hollow in the detection part (4) and connecting the wiring (8) with the detection device (14).

3. The semiconductor sensor according to claim 1 or 2,
comprising:
the plural hollow structure bodies (3) are separated into plural hollow structure groups (21) which are not spatially joined with each other, and
each of the hollow structure groups (21) has at least one detection part (4) and at least one getter part (5).

4. The semiconductor sensor according to claim 3,
wherein the detection part (4) and the getter part (5) are arranged in one of longitudinally or laterally aligned columns, are spatially joined together via the tunnel portion (7) and share a vacuum space in at least one of the columns in each of the hollow structure groups (21).

5. The semiconductor sensor according to claim 3,
wherein the detection part (4) and the getter part (5) are arranged longitudinally and laterally, spatially joined together via the tunnel portion (7) in each section formed with two or more rows and two or more columns and share a vacuum space in each of the hollow structure groups (21).

6. The semiconductor sensor according to claim 2,
wherein the getter (16) is applied onto a hollow substrate (13) retained to be hollow by the support leg (12).

7. The semiconductor sensor according to claim 2,
wherein the detection device (14) is formed in a hollow substrate (13) retained to be hollow by the support leg (12) in the detection part (4) and the getter part (5), and
the getter (16) is applied onto the hollow substrate (13) in which the detection device (14) is formed in the getter part (5).

8. The semiconductor sensor according to any one of claims 1 to 7,
wherein the getter (16) is applied onto an upper portion on an inner side of the sealing material support body (10) in the getter part (5).

9. The semiconductor sensor according to any one of claims 1 to 7,
wherein the getter (16) has hollow wiring (22) formed of metal, and the hollow wiring (22) is electrically heatable.

10. The semiconductor sensor according to any one of claims 1 to 9,
wherein the tunnel portion (7) is formed by hollowing out the support body (6) in a part of one side of the hollow structure body (3) having a rectangular shape in a planar view and is arranged to be spaced away from a corner of the hollow structure body (3).

11. The semiconductor sensor according to any one of claims 1 to 9,
wherein the tunnel portion (7) is formed by hollowing out the support body (6) in a part of one side of the hollow structure body (3) having a rectangular shape in a planar view and is arranged to be adjacent to a corner of the hollow structure body (3).

12. The semiconductor sensor according to any one of claims 1 to 11,
wherein the support body (6) has a semiconductor (24) as a part of the semiconductor substrate (1) and an oxide (23) provided to surround the semiconductor (24) along an outer periphery of the support body (6).

13. The semiconductor sensor according to any one of claims 1 to 12,
wherein the detection device (14) is a thermal infrared detection device.

14. A method for manufacturing the semiconductor sensor according to claim 2, comprising:
- forming an oxide film (15) on a main surface of the semiconductor substrate (1) and forming the detection device (14) on the oxide film (15);
- forming a groove (17) in the main surface of the semiconductor substrate (1) by etching;
- filling the groove (17) with an oxide (23) to form the support body (6);
- forming the wiring (8) on the support body (6);
- forming the support leg (12) on the main surface of the semiconductor substrate (1);
- forming a sacrificial layer (18) on the main surface of the semiconductor substrate (1) so as to cover the detection device (14), the wiring (8), and the support leg (12);
- removing the sacrificial layer (18) on the wiring (8) to form an opening (19);
- forming the sealing material support body (10) in an internal portion of the opening (19) and on the sacrificial layer (18);
- forming an etching hole (20) passing through the sealing material support body (10) and the sacrificial layer (18);
- selectively etching the semiconductor substrate (1) via the etching hole (20) to form the hollow structure body (3) and the tunnel portion (7);
- after forming the hollow structure body (3) and the tunnel portion (7), removing the sacrificial layer (18); and
- after removing the sacrificial layer (18), depositing the sealing material (11) on the sealing material support body (10) under a vacuum condition and blocking the etching hole (20) to seal the hollow structure body (3) in a vacuum state.

15. The method for manufacturing the semiconductor sensor according to claim 14, comprising applying the getter (16) on the main surface of the semiconductor substrate (1) covered by the oxide film (15).

16. The method for manufacturing the semiconductor sensor according to claim 14, comprising applying the getter (16) on the sacrificial layer (18).

## Patentansprüche

1. Halbleitersensor, der das Folgende aufweist:
- ein einzelnes Halbleitersubstrat (1);
- mehrere Hohlstrukturkörper (3), die in dem Halbleitersubstrat (1) in einer Anordnung ausgebildet sind und ein Detektionsteil (4) als eine Hohlstruktur und ein Getterteil (5) als eine Hohlstruktur aufweisen, das sich von dem Detektionsteil (4) unterscheidet;
- einen Stützkörper (6), der die mehreren Hohlstrukturkörper (3) abgrenzt;
- einen Dichtungsmaterial-Stützkörper (10), der auf den Stützkörper (6) laminiert ist; und
- ein Dichtungsmaterial (11), das auf dem Dichtungsmaterial-Stützkörper (10) angeordnet ist und die mehreren Hohlstrukturkörper (3) vakuumdicht abdichtet,
- wobei das Detektionsteil (4) im Inneren eine Detektionsvorrichtung (14) aufweist,
- das Getterteil (5) im Inneren einen Getter (16) aufweist,
- das Detektionsteil (4) und das Getterteil (5) räumlich miteinander verbunden sind, und zwar durch einen Tunnelbereich (7), der in dem Stützkörper (6) ausgebildet ist, um eine Hohlstrukturgruppe (21) zu bilden, die sich einen Vakuumraum teilen, und
- das Detektionsteil (4) und das Getterteil (5) der Hohlstrukturgruppe (21) durch die Hohlstruktur in einem Vakuumraum eingeschlossen sind, der durch das Dichtungsmaterial (11) und den Stützkörper (6) verschlossen bzw. unterteilt ist.

2. Halbleitersensor nach Anspruch 1,
der das Folgende aufweist:
eine Verdrahtung (8), die an dem Stützkörper (6) ausgebildet ist; und
ein Stützbein (12), das die Detektionsvorrichtung (14) so hält, dass sie hohl ist, das in dem Detektionsteil (4) angeordnet ist und das die Verdrahtung (8) mit der Detektionsvorrichtung (14) verbindet.

3. Halbleitersensor nach Anspruch 1 oder 2,
der das Folgende aufweist:
die mehreren Hohlstrukturkörper (3), die in mehrere Hohlstrukturgruppen (21) unterteilt sind, die räumlich nicht miteinander verbunden sind, und
wobei jede der Hohlstrukturgruppen (21) zumindest ein Detektionsteil (4) und zumindest ein Getterteil (5) aufweist.

4. Halbleitersensor nach Anspruch 3,
wobei das Detektionsteil (4) und das Getterteil (5) in einer von in Längs- oder Querrichtung ausgerichteten Spalten angeordnet sind, über den Tunnelbereich (7) räumlich miteinander verbunden sind und sich einen Vakuumraum in zumindest einer der Spalten in der jeweiligen Hohlstrukturgruppe (21) teilen.

5. Halbleitersensor nach Anspruch 3,
wobei das Detektionsteil (4) und das Getterteil (5) in Längs- und Querrichtung angeordnet sind, räumlich über den Tunnelbereich (7) miteinander verbunden sind, und zwar in jedem Bereich, der aus zwei oder mehr Reihen und zwei oder mehr Spalten gebildet ist, und sich einen Vakuumraum in der jeweiligen Hohlstrukturgruppe (21) teilen.

6. Halbleitersensor nach Anspruch 2,
wobei der Getter (16) auf ein Hohlsubstrat (13) aufgebracht ist, das durch das Stützbein (12) so gehalten ist, das es hohl ist.

7. Halbleitersensor nach Anspruch 2,
wobei die Detektionsvorrichtung (14) in einem Hohlsubstrat (13), das durch das Stützbein (12) so gehalten ist, dass es hohl ist, in dem Detektionsteil (4) und in dem Getterteil (5) ausgebildet ist, und
der Getter (16) auf das Hohlsubstrat (13) aufgebracht ist, in dem die Detektionsvorrichtung (14) in dem Getterteil (5) ausgebildet ist.

8. Halbleitersensor nach einem der Ansprüche 1 bis 7,
wobei der Getter (16) auf einen oberen Bereich an einer Innenseite des Dichtungsmaterial-Stützkörpers (10) in dem Getterteil (5) aufgebracht ist.

9. Halbleitersensor nach einem der Ansprüche 1 bis 7,
wobei der Getter (16) eine aus Metall gebildete Hohlverdrahtung (22) aufweist und die Hohlverdrahtung (22) elektrisch beheizbar ist.

10. Halbleitersensor nach einem der Ansprüche 1 bis 9,
wobei der Tunnelbereich (7) durch Aushöhlen des Stützkörpers (6) in einem Teil von der einen Seite des Hohlstrukturkörpers (3) gebildet ist, der eine in einer Draufsicht rechteckige Form aufweist, und so angeordnet ist, dass er von einer Ecke des Hohlstrukturkörpers (3) beabstandet ist.

11. Halbleitersensor nach einem der Ansprüche 1 bis 9,
wobei der Tunnelbereich (7) durch Aushöhlen des Stützkörpers (6) in einem Teil von der einen Seite des Hohlstrukturkörpers (3) ausgebildet ist, der eine in einer Draufsicht rechteckige Form aufweist, und so angeordnet ist, dass er an eine Ecke des Hohlstrukturkörpers (3) angrenzt.

12. Halbleitersensor nach einem der Ansprüche 1 bis 11,
wobei der Stützkörper (6) einen Halbleiter (24) als einen Teil des Halbleitersubstrats (1) und ein Oxid (23) aufweist, das so ausgebildet ist, dass es den Halbleiter (24) entlang eines Außenumfangs des Stützkörpers (6) umgibt.

13. Halbleitersensor nach einem der Ansprüche 1 bis 12,
wobei die Detektionsvorrichtung (14) eine thermische Infrarot-Detektionsvorrichtung ist.

14. Verfahren zum Herstellen des Halbleitersensors nach Anspruch 2,
das die folgenden Schritte umfasst:
- Ausbilden einer Oxidschicht (15) auf einer Hauptfläche des Halbleitersubstrats (1) und Ausbilden der Detektionsvorrichtung (14) auf der Oxidschicht (15);
- Ausbilden einer Nut (17) in der Hauptfläche des Halbleitersubstrats (1) durch Ätzen;
- Füllen der Nut (17) mit einem Oxid (23), um den Stützkörper (6) auszubilden;
- Ausbilden der Verdrahtung (8) auf dem Stützkörper (6);
- Ausbilden des Stützbeins (12) auf der Hauptfläche des Halbleitersubstrats (1);
- Ausbilden einer Opferschicht (18) auf der Hauptfläche des Halbleitersubstrats (1), um die Detektionsvorrichtung (14), die Verdrahtung (8) und das Stützbein (12) zu bedecken;
- Entfernen der Opferschicht (18) auf der Verdrahtung (8), um eine Öffnung (19) auszubilden;
- Ausbilden des Dichtungsmaterial-Stützkörpers (10) in einem inneren Bereich der Öffnung (19) und auf der Opferschicht (18);
- Ausbilden eines Ätzlochs (20), das durch den Dichtungsmaterial-Stützkörper (10) und die Opferschicht (18) hindurchgeht;
- selektives Ätzen des Halbleitersubstrats (1) durch das Ätzloch (20), um den Hohlstrukturkörper (3) und den Tunnelbereich (7) auszubilden;
- nach dem Ausbilden des Hohlstrukturkörpers (3) und des Tunnelbereichs (7), Entfernen der Opferschicht (18); und
- nach dem Entfernen der Opferschicht (18), Aufbringen des Dichtungsmaterials (11) unter Vakuumbedingungen auf den Dichtungsmaterial-Stützkörper (10) und Verschließen des Ätzlochs (20), um den Hohlstrukturkörper (3) unter Vakuum abzudichten.

15. Verfahren zum Herstellen des Halbleitersensors nach Anspruch 14,
umfassend das Aufbringen des Getters (16) auf die Hauptfläche des Halbleitersubstrats (1), das mit der Oxidschicht (15) bedeckt ist.

16. Verfahren zum Herstellen des Halbleitersensors nach Anspruch 14,
umfassend ein Aufbringen des Getters (16) auf die Opferschicht (18).

## Revendications

1. Capteur semi-conducteur comprenant :
- un unique substrat semi-conducteur (1) ;
- une pluralité de corps à structures creuses (3) formés en réseau dans le substrat semi-conducteur (1) et ayant une partie de détection (4) en tant que structure creuse et une partie de piégeage dite getter (5) en tant que structure creuse différente de la partie de détection (4) ;
un corps de support (6) délimitant la pluralité de corps à structures creuses (3) ;
- un corps de support à matériau d'étanchéité (10) stratifié sur le corps de support (6), et
- un matériau d'étanchéité (11) prévu sur le corps de support à matériau d'étanchéité (10) et étanchant sous vide la pluralité de corps à structures creuses (3),
- dans lequel la partie de détection (4) a un dispositif de détection (14) à l'intérieur,
- la partie getter (5) a un élément de piégeage dit getter (16) à l'intérieur,
- la partie de détection (4) et la partie getter (5) sont spatialement jointes ensemble par une portion tunnel (7) formée dans le corps de support (6) pour constituer un groupe à structures creuses (21) partageant un espace sous vide, et
- la partie de détection (4) et la partie getter (5) du groupe à structures creuses (21) sont étanchées à travers la structure creuse dans un espace sous vide fermé et séparé par le matériau d'étanchéité (11) et le corps de support (6) respectivement.

2. Capteur semi-conducteur selon la revendication 1,
comprenant :
un câblage (8) formé sur le corps de support (6) ; et
une jambe de support (12) maintenant le dispositif de détection (14) à l'état creux dans la partie de détection (4) et connectant le câblage (8) au dispositif de détection (14).

3. Capteur semi-conducteur selon la revendication 1 ou 2,
comprenant :
la pluralité de corps à structures creuses (3) sont séparés en une pluralité de groupes à structures creuses (21) qui ne sont pas spatialement joints les uns aux autres, et
chacun des groupes à structures creuses (21) a au moins une partie de détection (4) et au moins une partie getter (5).

4. Capteur semi-conducteur selon la revendication 3,
dans lequel la partie de détection (4) et la partie getter (5) sont agencées soit en colonne alignée de manière longitudinale, soit en colonne alignée de manière latérale, sont spatialement joints ensemble via la portion tunnel (7) et partagent un espace sous vide dans l'une au moins des colonnes dans chacun des groupes à structures creuses (21).

5. Capteur semi-conducteur selon la revendication 3,
dans lequel la partie de détection (4) et la partie getter (5) sont agencées longitudinalement et latéralement, spatialement jointes ensemble via la portion tunnel (7) dans chaque section formée par deux ou plusieurs rangées et deux ou plusieurs colonnes, et partagent un espace sous vide dans chacun des groupes à structures creuses (21).

6. Capteur semi-conducteur selon la revendication 2,
dans lequel le getter (16) est appliqué sur un substrat creux (13) maintenu à l'état creux par la jambe de support (12).

7. Capteur semi-conducteur selon la revendication 2,
dans lequel le dispositif de détection (14) est formé dans un substrat creux (13) maintenu à l'état creux par la jambe de support (12) dans la partie de détection (4) et dans la partie getter (5), et
le getter (16) est appliqué sur le substrat creux (13) dans lequel le dispositif de détection (14) est formé dans la partie getter (5).

8. Capteur semi-conducteur selon l'une quelconque des revendications 1 à 7, dans lequel le getter (16) est appliqué sur une portion supérieure sur un côté intérieur du corps de support à matériau d'étanchéité (10) dans la partie getter (5).

9. Capteur semi-conducteur selon l'une quelconque des revendications 1 à 7, dans lequel le getter (16) a un câblage creux (22) formé en métal, et le câblage creux (22) peut être chauffé électriquement.

10. Capteur semi-conducteur selon l'une quelconque des revendications 1 à 9, dans lequel la portion tunnel (7) est formée en creusant le corps de support (6) dans une partie d'un côté du corps à structures creuses (3) ayant une forme rectangulaire dans une vue en plan et est agencée de façon à être espacée en éloignement d'un coin du corps à structures creuses (3).

11. Capteur semi-conducteur selon l'une quelconque des revendications 1 à 9, dans lequel la portion tunnel (7) est formée en creusant le corps de support (6) dans une partie d'un côté du corps à structures creuses (3) ayant une forme rectangulaire dans une vue en plan et est agencée de façon à être adjacente à un coin du corps à structures creuses (3).

12. Capteur semi-conducteur selon l'une quelconque des revendications 1 à 11, dans lequel le corps de support (6) a un semi-conducteur (24) en tant que partie du substrat semi-conducteur (1) et un oxyde (23) prévu de façon à entourer le semi-conducteur (24) le long d'une périphérie extérieure du corps de support (6).

13. Capteur semi-conducteur selon l'une quelconque des revendications 1 à 12, dans lequel le dispositif de détection (14) est un dispositif de détection infrarouge thermique.

14. Procédé de fabrication du capteur semi-conducteur selon la revendication 2, comprenant les étapes consistant à :
- former un film d'oxyde (15) sur une surface principale du substrat semi-conducteur (1) et former le dispositif de détection (14) sur le film d'oxyde (15) ;
- former une rainure (17) dans la surface principale du substrat semi-conducteur (1) par gravure ;
- remplir la rainure (17) avec un oxyde (23) pour former le corps de support (6) ;
- former le câblage (8) sur le corps de support (6) ;
- former la jambe de support (12) sur la surface principale du substrat semi-conducteur (1) ;
- former une couche sacrificielle (18) sur la surface principale du substrat semi-conducteur (1) de manière à recouvrir le dispositif de détection (14), le câblage (8), et la jambe de support (12) ;
- enlever la couche sacrificielle (18) sur le câblage (8) pour former une ouverture (19) ;
- former le corps de support à matériau d'étanchéité (10) dans une portion interne de l'ouverture (19) et sur la couche sacrificielle (18) ;
- former un trou de gravure (20) passant à travers le corps de support à matériau d'étanchéité (10) et la couche sacrificielle (18) ;
- graver sélectivement le substrat semi-conducteur (1) via le trou de gravure (20) pour former le corps à structures creuses (3) et la portion tunnel (7) ;
- après avoir formé le corps à structures creuses (3) et la portion tunnel (7), enlever la couche sacrificielle (18) ; et
- après avoir enlevé la couche sacrificielle (18), déposer le matériau d'étanchéité (11) sur le corps de support à matériau d'étanchéité (10) dans une condition sous vide et bloquer le trou de gravure (20) pour étancher le corps à structures creuses (3) dans un état sous vide.

15. Procédé de fabrication du capteur semi-conducteur selon la revendication 14,
comprenant l'étape consistant à appliquer le getter (16) sur la surface principale du substrat semi-conducteur (1) recouvert par le film d'oxyde (15).

16. Procédé de fabrication du capteur semi-conducteur selon la revendication 14,
comprenant l'étape consistant à appliquer le getter (16) sur la couche sacrificielle (18).
